# EUROPEAN PATENT APPLICATION

(11) **EP 4 650 974 A1**
(43) Date of publication of application: **19.11.2025**
(21) Application number: 25153270.1
(22) Date of filing: 22.01.2025
(51) Int. Cl.: G06F 13/16, G06F 13/42, G11C 7/10, G11C 16/32, G11C 29/02, G11C 29/50

(54) **A STORAGE SYSTEM AND OPERATING METHOD OF THE SAME**

(30) Priority: 17.05.2024 KR 20240064811
(71) Applicant: Samsung Electronics Co., Ltd., Suwon-si, Gyeonggi-do 16677 (KR)
(72) Inventor: SHIN, Seo-Hyun, 16677 Suwon-si, Gyeonggi-do (KR); KIM, You Hwan, 16677 Suwon-si, Gyeonggi-do (KR); LEE, Kyung Duk, 16677 Suwon-si, Gyeonggi-do (KR); JO, Dae Hyeon, 16677 Suwon-si, Gyeonggi-do (KR)
(74) Representative: Kuhnen & Wacker Patent- und Rechtsanwaltsbüro PartG mbB

(57) **Abstract**

An operating method of a storage system includes transmitting a first access command to a first non-volatile memory device, checking a status of the first non-volatile memory device, and performing a first ZQ calibration on the first non-volatile memory device through a DQ pin of the first non-volatile memory device during a time when the first non-volatile memory device is in a busy status.

## Description

### BACKGROUND

### 1. Field

The present invention relates to a storage system including a non-volatile memory device.

### 2. Description of the Related Art

As electronic devices become faster and consume low power, storage devices used for the same are desirable to have high capacity and operate at high speed.

As the storage devices including a plurality of non-volatile memory devices become higher capacity, research for maintaining SI (signal integrity) of a memory interface is being actively conducted.

### SUMMARY

Aspects of the present invention provide a storage system and an operating method thereof in which SI (signal integrity) performance is improved.

However, aspects of the present invention are not restricted to the one set forth herein. The above and other aspects of the present invention will become more apparent to one of ordinary skill in the art to which the present invention pertains by referencing the detailed description of the present invention given below.

According to an aspect of the present disclosure, an operating method of a storage system includes transmitting a first access command to a first non-volatile memory device, checking a status of the first non-volatile memory device, and performing a first ZQ calibration on the first non-volatile memory device through a DQ pin of the first non-volatile memory device during a time when the first non-volatile memory device is in a busy status.

According to an aspect of the present disclosure, a storage system includes a storage controller, and a plurality of non-volatile memory devices connected to the storage controller with a first signal line for transmitting a command and an address and a second signal line for transmitting data. The first signal line and the second signal line are separated from each other. The storage controller transmits an access command as the command to a first non-volatile memory device of the plurality of non-volatile memory devices using the first signal line, receives a logic level of a ready/busy signal using a R/B pin of the first non-volatile memory device during a time when an operation corresponding to the access command is performed on the first non-volatile memory device, checks a status of the first non-volatile memory device on the first signal line, performs, in response to the logic level of the ready/busy signal representing a busy status, a ZQ calibration on the first non-volatile memory device, and checks, after the performing of the ZQ calibration, the status of the first non-volatile memory device.

According to an aspect of the present disclosure, a storage system includes a plurality of non-volatile memory devices, and a storage controller connected to the plurality of non-volatile memory devices. The storage controller performs a first ZQ calibration on the plurality of non-volatile memory devices which are turned on, transmits an access command through a DQ pin each of the plurality of non-volatile memory devices, receives a busy status signal indicating a busy status from each of the plurality of non-volatile memory devices operating in response to the access command, performs a second ZQ calibration on the plurality of non-volatile memory devices, and checks whether the second ZQ calibration is correctly performed on each of the plurality of non-volatile memory devices.

### BRIEF DESCRIPTION OF THE DRAWINGS

The above and other aspects and features of the present invention will become more apparent by describing in detail exemplary embodiments thereof with reference to the attached drawings, in which:
FIG. 1 shows a storage system according to some embodiments;
FIG. 2 is a block diagram showing a storage device according to some embodiments;
FIG. 3 is a conceptual diagram showing a semiconductor package according to some embodiments;
FIG. 4 is a flowchart showing an operating method of a storage system according to some embodiments;
FIG. 5 is a diagram showing a storage system according to some embodiments;
FIG. 6 is a timing diagram showing that the non-volatile memory device of FIG. 5 performs the ZQ calibration during a read operation according to some embodiments;
FIG. 7 is a timing diagram for explaining a channel status of the storage system of FIG. 5 in which the ZQ calibration is performed according to some embodiments;
FIG. 8 is a timing diagram for explaining the channel status of the storage system of FIG. 5 in which ZQ calibration is performed according to some embodiments;
FIG. 9 is a timing diagram for explaining the channel status of the storage system of FIG. 5 in which the ZQ calibration is performed according to some embodiments;
FIGS. 10 and 11 are timing diagrams for explaining the channel status of the storage system of FIG. 5 in which the ZQ calibration is performed according to some embodiments;
FIG. 12 is a timing diagram showing that the ZQ calibration is performed, while the non-volatile memory device of FIG. 5 according to some embodiments performs the program operation;
FIG. 13 is a timing diagram for explaining the channel status of the storage system of FIG. 5 in which the ZQ calibration is performed according to some embodiments;
FIG. 14 is a timing diagram showing that the non-volatile memory device of FIG. 5 according to some embodiments performs the ZQ calibration during an erase operation;
FIG. 15 is a conceptual diagram showing a storage system connected in an SCA manner according to some embodiments;
FIG. 16 is a timing diagram showing that the non-volatile memory device of FIG. 15 performs the ZQ calibration during a read operation, according to some embodiments;
FIG. 17 is a timing diagram showing that the non-volatile memory device of FIG. 15 performs the ZQ calibration during an erase operation, according to some embodiments;
FIG. 18 is a timing diagram showing that the non-volatile memory device of FIG. 15 performs the ZQ calibration during a program operation, according to some embodiments; and
FIGS. 19 to 21 are timing diagrams for explaining an operating method of the storage system according to some embodiments.

### DETAILED DESCRIPTION OF THE EMBODIMENTS

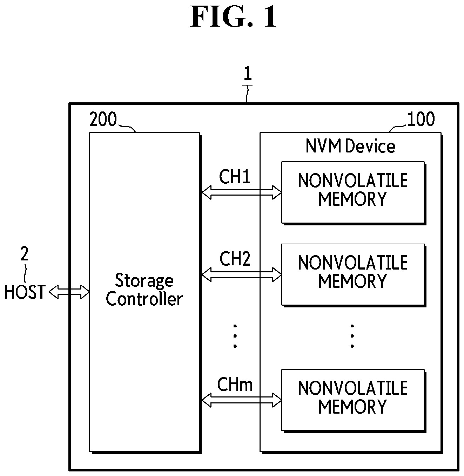

Hereinafter, a storage system according to some embodiments of the present invention will be described with reference to FIGS. 1 to 21.

FIG. 1 shows a storage system according to some embodiments.

Referring to FIG. 1, an electronic system according to an embodiment of the present invention includes a host 2 and a storage system 1. The electronic system may be implemented as a personal computer (PC) or data server, a laptop computer or a portable device. The portable device may be implemented as a mobile phone, a smart phone, a tablet PC, a personal digital assistant (PDA), an enterprise digital assistant (EDA), a digital still camera, a digital video camera, a portable multimedia player (PMP), a personal navigation device or a portable navigation device (PND), a handheld game console or an e-book. In some embodiments, the electronic system may be implemented as a system-on-a-chip (SoC).

The host 2 may include a host control unit that controls the overall operation of the electronic system 1. The host control unit may control the self-operation of the host 2 and the operation of the electronic system 1. The host control unit may generate commands for controlling the operation of the electronic system 1 and transmit the commands to the electronic system 1.

The host 2 may request a data processing operation, for example, a data read operation, a data write (program) operation, a data erase operation or the like, from the storage system 1. For example, the host 2 may be a central processing unit (CPU), a graphic processing unit (GPU), a microprocessor, an application processor (AP) or the like.

The storage system 1 includes a storage controller 200 and a non-volatile memory device 100. The storage system 1 may be implemented as various types of storage devices, such as a solid-state drive (SSD), an embedded multimedia card (eMMC), a universal flash storage (UFS), or a compact flash (CF), a secure digital (SD), a micro secure digital (Micro-SD), a mini secure digital (Mini-SD), an extreme digital (xD) or a memory stick.

The storage controller 200 of the storage system 1 may be coupled to the host 2. The storage controller 200 may be configured to access the non-volatile memory device 100 in response to a request from the host 2. For example, the storage controller 200 may be implemented to control the overall operation of the storage system 1. The storage controller 200 may perform various management operations such as a cache/buffer management, a firmware management, a garbage collection management, a wear leveling management, a data deduplication management, a read refresh/reclaim management, a bad block management, a multi-stream management, a mapping management of host data and non-volatile memory, a Quality of Service (QoS) management, a system resource allocation management, a non-volatile memory queue management, a read level management, an erase/program management, a hot/cold data management, a power loss protection management, a dynamic thermal management, and an initialization management.

Although it is not clearly shown in the drawings, the storage controller 200 may be configured to provide an interface between the storage system 1 and a host 2. Furthermore, the storage controller 200 may be configured to drive firmware for controlling the storage system 1 at the request of the host 2 or by itself.

As an example, the storage controller 200 may further include well-known components such as a memory, a controller control unit, a host interface, and a memory interface.

The host interface of the storage controller 200 may operate according to a protocol for performing a data exchange between the host 2 and the storage controller 200. As an example, the storage controller 200 may be configured to communicate with the host 2 through at least one of various interface protocols, such as a universal serial bus (USB) protocol, a multimedia card (MMC) protocol, a peripheral component interconnection (PCI) protocol, a PCI-express (PCI-E) protocol, an advanced technology attachment (ATA) protocol, a serial-ATA protocol, a Parallel-ATA protocol, a small computer small interface (SCSI) protocol, an enhanced small disk interface (ESDI) protocol, and an Integrated Drive Electronics (IDE) protocol.

The memory may be used as at least one of an operating memory of the controller control unit, a cache memory between the storage system 1 and the host 2, and a buffer memory between the storage system 1 and the host 2, and may be implemented, for example, as a random access memory (RAM).

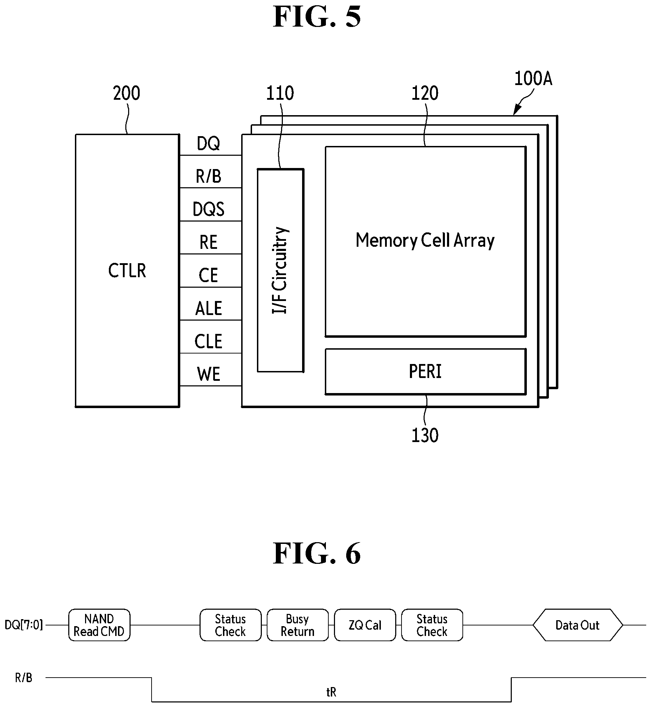

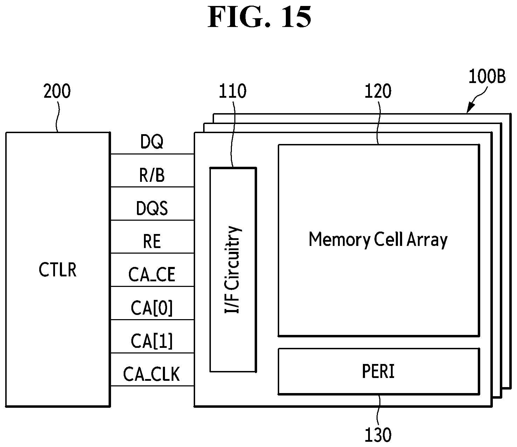

The memory interface of the storage controller 200 is electrically connected to an input/output interface circuit of the non-volatile memory device 100. The memory interface of the storage controller 200 may transmit and receive signals to and from the non-volatile memory device 100 through a plurality of pins. The memory interface will be specifically described in FIGS. 5 and 15.

The storage system 1 may include, for example, a plurality of non-volatile memory devices. The plurality of non-volatile memory devices may communicate with the storage controller 200 through, for example, first to m-th channels CH1 to CHm.

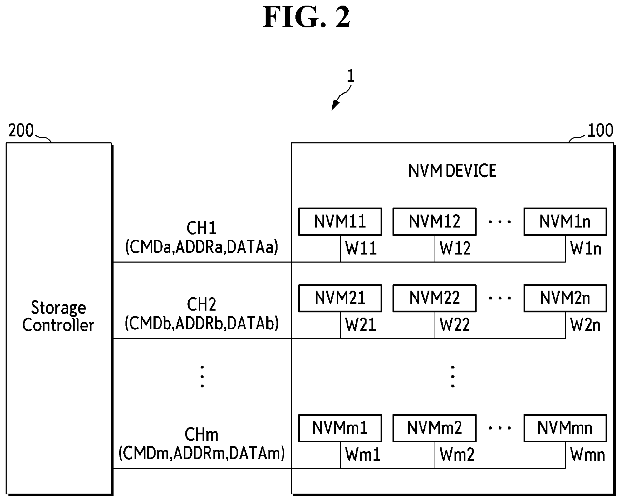

FIG. 2 is a block diagram showing a storage device according to some embodiments.

Referring to FIG. 2, the storage system 1 may include a non-volatile memory device 100 and the storage controller 200. The storage system 1 may support the plurality of channels CH1 to CHm, and the non-volatile memory device 100 and the storage controller 200 may be connected through the plurality of channels CH1 to CHm. For example, the storage system 1 may be implemented as a storage device such as a solid status drive (SSD).

The non-volatile memory device 100 may include a plurality of non-volatile memory devices NVM11 to NVMmn. Each of the non-volatile memory devices NVM11 to NVMmn may be connected to one of a plurality of channels CH1 to CHm through a corresponding way. For example, non-volatile memory devices NVM11 to NVM1n may be connected to a first channel CH1 through ways W11 to W1n, and non-volatile memory devices NVM21 to NVM2n may be connected to a second channel CH2 through ways W21 to W2n. In an exemplary embodiment, each of the non-volatile memory devices NVM11 to NVMmn may be implemented in any memory unit that may operate in accordance with individual instructions from the storage controller 200. For example, each of the non-volatile memory devices NVM11 to NVMmn may be implemented as a chip or a die. However, the present invention is not limited thereto.

The storage controller 200 may transmit and receive signals to and from the non-volatile memory device 100 through the plurality of channels CH1 to CHm. For example, the storage controller 200 may transmit commands CMDa to CMDm, addresses ADDRa to ADDRm, and data DATAa to DATAm to the non-volatile memory device 100 through the channels CH1 to CHm, or may receive the data DATAa to DATAm from the non-volatile memory device 100.

The storage controller 200 may select one of the non-volatile memory devices connected to the channel through each channel, and may transmit and receive signals to and from the selected non-volatile memory device. For example, the storage controller 200 may select a non-volatile memory device NVM11 among the non-volatile memory devices NVM11 to NVM1n connected to the first channel CH1. The storage controller 200 may transmit command CMDa, address ADDRa, and data DATAa to the selected non-volatile memory device NVM11 through the first channel CH1 or may receive the data DATAa from the selected non-volatile memory device NVM11.

The storage controller 200 may transmit and receive signals in parallel to and from the non-volatile memory device 100 through the plurality of channels CH1 to CHm different from each other. For example, the storage controller 200 may transmit a command CMDb to the non-volatile memory device 100 through the second channel CH2, while transmitting the command CMDa to the non-volatile memory device 100 through the first channel CH1. For example, the storage controller 200 may receive data DATAb from the non-volatile memory device 100 through the second channel CH2, while receiving the data DATAa from the non-volatile memory device 100 through the first channel CH1. In some embodiments, the storage controller 200 may receive in parallel data DATAa to DATAm from the non-volatile memory device 100 through the first to m-th channels CH1 to CHm, respectively.

The storage controller 200 may control the overall operation of the non-volatile memory device 100. The storage controller 200 may transmit the signal to the channels CH1 to CHm to control each of the non-volatile memory devices NVM11 to NVMmn connected to the channels CH1 to CHm. For example, the storage controller 200 may transmit the command CMDa and the address ADDRa to the first channel CH1 to control selected one of the non-volatile memory devices NVM11 to NVM1n. In some embodiments, the storage controller 200 may transmit in parallel the commands CMDa to CMDm and the addresses ADDRa to ADDRm to the channels CH1 to CHm, respectively.

Each of the non-volatile memory devices NVM11 to NVMmn may operate in accordance with the control of the storage controller 200. For example, a non-volatile memory device NVM11 may program the data DATAa in accordance with the command CMDa and the address ADDRa provided to the first channel CH1. For example, a non-volatile memory device NVM21 may read the data DATAb in accordance with the command CMDb and the address ADDRb provided to the second channel CH2, and may transmit the read data DATAb to the storage controller 200.

Although FIG. 2 shows that the non-volatile memory device 100 communicates with the storage controller 200 through m channels CH1 to CHm, and the non-volatile memory device 100 includes n non-volatile memory devices per channel, the number of channels and the number of non-volatile memory devices per channel may be variously changed.

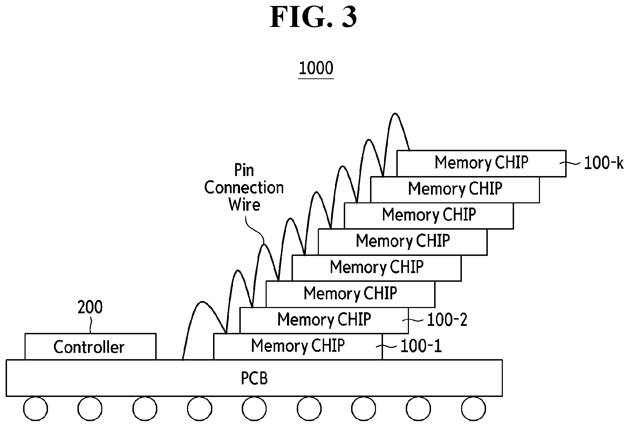

FIG. 3 is a conceptual diagram showing a semiconductor package according to some embodiments.

Referring to FIG. 3, the semiconductor package 1000 may include a substrate PCB, a storage controller 200, and semiconductor structures (100-1, 100-2,..., and 100-k; hereinafter, 100). The substrate PCB may be a printed circuit board (PCB). The substrate PCB may have a structure in which an insulating layer and a wiring layer are cross-stacked. In some embodiments, the semiconductor structures 100 may correspond to non-volatile memory devices connected to the same channel as shown in FIG. 2 (e.g., NVM11 to NVM1n).

The storage controller 200 and the semiconductor structures 100 may be disposed on an upper surface of the substrate PCB. External connection terminals may be disposed on a lower surface of the substrate PCB. The external connection terminals may be spaced apart from each other sideways. For example, the external connection terminals may include solder balls or solder bumps.

The storage controller 200 may be electrically connected to the semiconductor structures 100 through at least one of a wiring layer inside the substrate PCB and a pin connection wire (Pin Connection). In some embodiments, the pin connection wire may be connected to each of semiconductor structures 100, and the storage controller 200 may be connected to the wiring layer of the substrate PCB, which is connected to the pin connection wire.

The semiconductor structures 100 may be disposed to be stacked in a first direction (e.g., a vertical direction perpendicular to the upper surface of the substrate PCB). The semiconductor structures 100 may be disposed on the substrate PCB as an offset stack structure. For example, the semiconductor structures 100 may be stacked in an inclined manner in the first direction, which may be in the form of an ascending inclined staircase. Accordingly, a part of the upper surface of each semiconductor structure may be exposed for connection with the pin connection wire.

Each of the semiconductor structures 100 may include at least one non-volatile memory device. Each semiconductor structure may be electrically connected to the substrate PCB and the storage controller 200 through the pin connection wire (Pin Connection) to transmit and receive the signals. A plurality of pin connection wires (Pin Connection) may be provided as a metal material. For example, each of the plurality of pin connection wires may serve as a corresponding channel of the channels CH1 to CHm of FIG. 2.

The storage controller 200 may transmit independent control signals to each of the semiconductor structures 100. However, as the number of the semiconductor structures 100 included in the semiconductor package 1000 increases, frequency of input/output signals from the storage controller 200 to each semiconductor structure increases, and SI (Signal Integrity) issue may increase due to a high-capacity package. Therefore, a ZQ calibration is important during operation of signals transmitted to and received from each semiconductor package. In some embodiments, the semiconductor structures 100 connected to the same pin connection wire may receive a control signal from the storage controller 200. As the number of the semiconductor structures 100 per channel increases (i.e., more non-volatile memory devices are stacked on each other), the length of the pin connection wire and the number of contacts with the semiconductor structures 100 increase, thereby the SI being deteriorated. The storage controller 200 may perform a ZQ calibration operation for impedance matching between the storage controller 200 and the semiconductor structures 100. For example, the storage controller 200 may transmit a ZQ calibration signal to the semiconductor structures 100, and each of the semiconductor structures 100 may perform the ZQ calibration in response to the ZQ calibration signal.

As the operating environment of the storage system 2, for example, conditions such as a process, a voltage, and a temperature (PVT) change frequently, the circuit impedance changes. The ZQ calibration may stabilize the storage system 1 by reducing an impedance mismatch between the storage controller 200 and the non-volatile memory device in the semiconductor structure 100, by using impedance codes corresponding to various operating environments, to ensure the operating reliability of the storage system 2 even in a change in circuit impedance. That is, the ZQ calibration is an operation for equalizing a driver strength for each semiconductor structure to be constant for the operating environment.

However, the plurality of semiconductor structures included in the semiconductor package 1000 share the same ZQ calibration circuit. Since each semiconductor structure may only be calibrated on the basis of the resistance of the shared ZQ calibration circuit, there is a restriction that the signals operate serially. Accordingly, as the capacity of the semiconductor package increases, an open time at the time of the ZQ calibration operation may increase. Therefore, it is necessary to shorten the open operation of the ZQ calibration in the plurality of stacked semiconductor packages. In addition, even if the ZQ calibration is performed at the first operation, because the operating environment of the storage system changes during runtime, there is a need for a technique that may optimally set the ZQ calibration even during runtime.

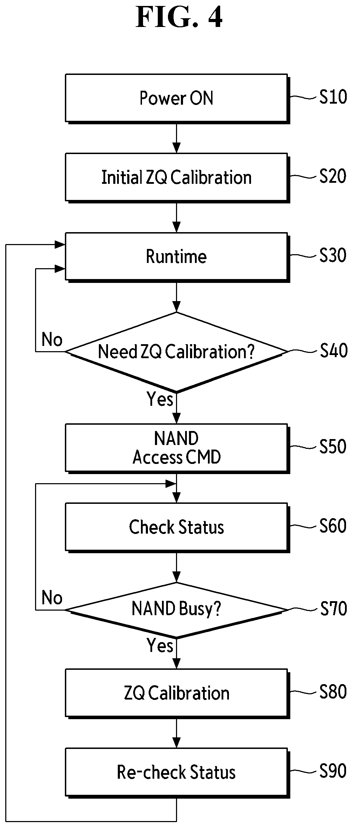

FIG. 4 is a flowchart showing an operating method of a storage system according to some embodiments.

Referring to FIG. 4, when the storage system 1 is powered on (S10), an initial ZQ calibration is performed (S20). The storage system 1 performs a general operation during runtime on the basis of the impedance code that is set in the initial ZQ calibration (S30).

The storage system 1 monitors the interface between the storage controller 200 and the non-volatile memory device whether the ZQ calibration is required again during the runtime (S40). If the ZQ calibration is required again (S40, Yes), the storage controller 200 checks the status of the non-volatile memory device 100 (S60), while transmitting an access command (e.g., a read command, a program command, or an erase command) to the non-volatile memory device 100 (S50). If the non-volatile memory device 100 is checked to be a busy status (S70, Yes), the ZQ calibration is performed again (S80). After the re-performed ZQ calibration, while the signal integrity (SI) status of the non-volatile memory device 100 is checked again (S90), and after checking whether the ZQ calibration was performed successfully (Pass) or not (Fail), the access operation according to S50 is continued (S30).

FIG. 5 is a diagram showing a storage system according to some embodiments.

The memory interface of the storage controller 200 may transmit and receive signals to and from the input/output interface 110 of the non-volatile memory device 100A through a number of pins. For example, the plurality of pins may transmit and receive DQ, R/B, DQS, RE, CE, ALE, CLE, and WE signals, respectively. The received signals may be transmitted to the memory cell array 120 through the peripheral circuit 130, and data stored in the memory cell array 120 or a status signal of the non-volatile memory device 100A are generated through the peripheral circuit 130, and may be transmitted to the storage controller 200 through the input/output interface 110.

A DQ signal is a data signal, and a command CMD, an address ADDR, and data DATA may be transferred. The DQ signal may be transferred through a plurality of data signal lines. An R/B signal is a signal indicating an operation status of the non-volatile memory device 100A. For example, the storage controller 200 may transmit signal of a busy status to the storage controller 200 when the non-volatile memory device 100A is operating, and the storage controller 200 may transmit signal of a ready status to the storage controller 200 when the non-volatile memory device 100A is in pause. For example, data may be encrypted for security or privacy. A DQS signal is a data strobe signal, and an RE signal is a read enable signal, which may be input as a data output control signal when reading data from the non-volatile memory device 100A. The RE signal may be used to generate the DQS signal. A CE signal is a chip enable signal, which is a signal by which the storage controller 200 selectively activates and accesses at least one of the non-volatile memory devices 100. A CLE signal is a command latch enable signal, and an ALE signal is an address latch enable signal. When the DQ signal includes a command CMD, the CLE signal is enabled. When the DQ signal includes an address ADDR, the ALE signal is enabled. When general data is transmitted to the DQ signal, the CLE signal or the ALE signal is disabled. A WE signal is a write enable signal, and the storage controller 200 may transmit the data signal DQ including the command CMD or the address ADDR and a switched write enable signal WE to the non-volatile memory device 100.

For example, the non-volatile memory device 100 may perform a program operation/read operation/erase operation by latching a command CMD or address ADD at the edge of the WE signal according to the CLE signal and the ALE signal. For example, the CE signal is activated at the time of the read operation, the CLE signal is activated in a transmission section of command, the ALE signal is activated in a transmission section of address, and the RE signal may be toggled in a section at which data is transmitted through the data signal line DQ. The DQS signal may be toggled at a frequency corresponding to the data input/output speed. The read data may be transmitted sequentially in synchronization with the data strobe signal DQS.

Each of the plurality of pins may transmit and receive signals independently of each other. According to some embodiments, when the storage controller 200 transmits an access command and an address in a read/program/erase operation to the non-volatile memory device 100A through the DQ pin, the non-volatile memory device 100A transmits an R/B signal indicating a busy status through the R/B pin, while performing an operation corresponding to the access command. For example, when the signal is transmitted through the R/B pin, the DQ pin may be unused. The ZQ calibration may be performed when the R/B pin transmits the busy status signal and the DQ pin is unused.

The non-volatile memory device 100 may support a Plane Independent Command (PIC).

FIG. 6 is a timing diagram showing that the non-volatile memory device of FIG. 5 performs the ZQ calibration during a read operation according to some embodiments.

Referring to FIG. 6, when the storage controller 200 transmits a read command (Read CMD) through the DQ pin, the non-volatile memory device 100 transmits a logic-low ready/busy signal through the R/B pin while performing the read operation associated with the read command. In the timing diagram of the R/B pin, a logic-low section that is in a busy status due to the read operation is represented as tR. For example, the time period during which the ready/busy signal has a level of a logic low corresponds to a read operation time tR of the read operation.

While the logic-low ready/busy signal is being transmitted through the R/B pin, the storage controller 200 transmits a status check command (Status Check), and the non-volatile memory device 100 checks an internal status and replies with a busy status (Busy Return). When the storage controller 200 receives the reply of the busy status from the non-volatile memory device 100, it performs the ZQ calibration with the non-volatile memory device 100 (ZQ Cal). Thereafter, the storage controller 200 checks whether the ZQ calibration is performed correctly (whether status Pass/Fail) through a status check (Status Check) of the non-volatile memory device 100. In some embodiments, the non-volatile memory device 100 may have a status register of which a stored value indicates whether the ZQ calibration was successful (i.e., correctly performed). For example, after performing the ZQ calibration on the non-volatile memory device 100, the storage controller 200 may read a specific bit in the status register to check the ZQ calibration result. When the non-volatile memory device 100 completes data read from the memory cell array 120, the R/B pin transmits the logic high signal of the ready status, and transmits the read data through the DQ pin (Data Out).

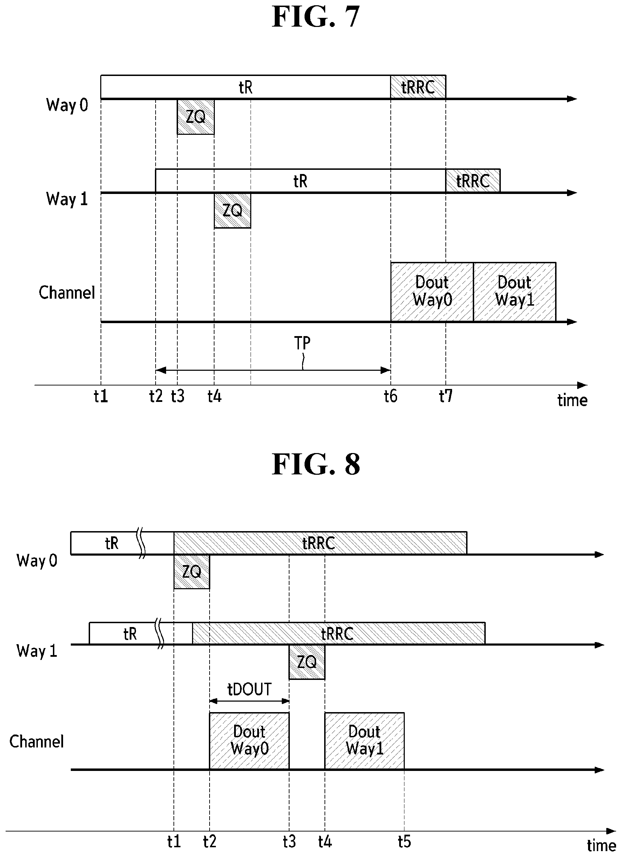

FIGS. 7, 8, and 9 are timing diagrams for explaining the channel status of the storage system of FIG. 5 in which ZQ calibration is performed. The operation of the semiconductor structure 100 and the storage controller 200 at the time of the read operation including the plurality of non-volatile memories NVM will be described referring to FIGS. 1, 2 and 3 together. Assume that a first non-volatile memory device NVM11 and a second non-volatile memory device NVM12 are connected to a first channel (Channel), the first non-volatile memory device NVM11 is connected to a first way WayO of the first channel CH1, and the second non-volatile memory device NVM12 is connected to a second way Way1 of the first channel.

The first non-volatile memory device NVM11 and the second non-volatile memory device NVM12 transmit the data from the memory cell array to the page buffer in the read operation time tR (i.e., a memory cell-to-buffer read time) at which the read operation is performed, and transmit data of the page buffer to the channel, while discharging the word line in a tRRC section (i.e., a time from Read Ready to new command tRRC) when the read operation is completed. The tRRC section is the time from Read Ready status to a new command, and the tRRC shortens the length of the tR section. By the tRRC section, the memory device changes its status (i.e., external busy signal is enabled) to allow DMA (direct memory access) before an internal finish-read operation.

The read operation time tR includes 3 section. A first section of the read operation time is performed an internal pump enable operation to prepare the regular data read operation. A second section of the read operation time tR is performed the regular read operation(or read core operation.) A third section of the read operation time tR is performed an internal pump disable operation, such as pump recovery. The third section of the read operation time tR is newly defined as the time from read ready to new command tRRC, , which is release "external busy" status for free DMA(Direct Memory Access). That is, the read operation time tR refers to the time to access the memory cell and transmit data to the page buffer. A length of the read operation time tR may vary depending on whether the memory cell is a single-level cell or a multi-level, the position of the memory cell to be accessed, and the like. A length of the time from read ready to new command tRRC may vary depending on how much data stored in the page buffer should be output to the way or the channel. In the read operation of the first non-volatile memory device NVM11 of the first way WayO of the first channel CH1, data stored in the memory cell array 120 may be transmitted to the page buffer during a period from time t1 to time t6, and a word line may be discharged during a period from time t6 to time t7 (i.e., during the time from read ready to new command tRRC). In FIGS. 5 and 6, the memory device 100A may be in a busy status (EXTERNAL BUSY) only before the time from read ready to new command tRRC.

FIG. 7 is a timing diagram for explaining a channel status of the storage system of FIG. 5 in which the ZQ calibration is performed according to some embodiments.

Referring to FIG. 7, the first non-volatile memory device NVM11 and the second non-volatile memory device NVM12 sequentially start the read operation depending on the reception time of the read command from the storage controller 200. For example, the first non-volatile memory device NVM11 performs the read operation during a section from time t1 to time t6, and the second non-volatile memory device NVM12 performs the read operation during a section from time t2 to time t7. That is, the start time (e.g., time 11) of the read operation of the first non-volatile memory device NVM11 may be different from the start time (e.g., time t2), later than the start time (e.g., time 11), of the read operation of the second non-volatile memory device NVM12.

In addition, the read data from the first and second non-volatile memory devices NVM11 and NVM12 may be output serially through the channel without overlapping each other. The first non-volatile memory device NVM11 may output data (Dout WayO) that is read at time t6 to the channel through the first way WayO, and the second non-volatile memory device NVM12 may output data (Dout Way1) that is read to the channel through the second way Way1.

According to some embodiments, the storage controller 200 may perform the ZQ calibration on each non-volatile memory device in the tR section. The storage controller 200 may serially perform the ZQ calibration of the first non-volatile memory device and the second non-volatile memory device. For example, the storage controller may perform the ZQ calibration on the first non-volatile memory device from time t3, and may perform the ZQ calibration on the second non-volatile memory device from time t4 when the calibration of the first non-volatile memory device is completed. However, the ZQ calibration of each non-volatile memory device may be performed in the TP section at which the R/B pins of all non-volatile memory devices are in the busy status and the DQ pin of the channel is unused. For example, the TP section may correspond to a time window in which the tR sections of all non-non-volatile memory devices in the same channel overlap, thereby no DQ pin of the channel is being used during the TP section and enabling the DQ pin to be used for a ZQ calibration. For example, during a time (e.g., the TP section) in which each of the non-volatile memory devices in the same channel is in a busy status, the ZQ calibration is performed on each of the non-volatile memory devices. For the sake of simplicity of description, in FIG. 7, it is assumed that a channel has two ways only.

FIG. 8 is a timing diagram for explaining the channel status of the storage system of FIG. 5 in which ZQ calibration is performed according to some embodiments.

Referring to FIG. 8, when the tRRC section is longer than the data output time tDOUT (tRRC>tDOUT) according to some embodiments, the storage controller may perform the ZQ calibration in the tRRC section.

For example, the first non-volatile memory device NVM11 and the second non-volatile memory device NVM12 each perform the read operation at the read operation time tR in response to a read command received from the storage controller 200. The first non-volatile memory device NVM11 and the second non-volatile memory device NVM12 then sequentially output the data read during the tRRC section. The read data output from the first non-volatile memory device NVM11 to the channel may not overlap the read data output from the second non-volatile memory device NVM12. However, unlike FIG. 7, at the start time (e.g., time 11) of the first tRRC section, the ZQ calibration is performed on the first non-volatile memory device NVM11, and then the first data read from the first non-volatile memory device NVM11 may be output to the channel (Dout WayO) at time t2. At time t3 when the output of the first data is completed, the storage controller performs the ZQ calibration on the second non-volatile memory device NVM12, and then the second non-volatile memory device NVM12 may output the second data read to the channel (Dout Way 1) at time t4.

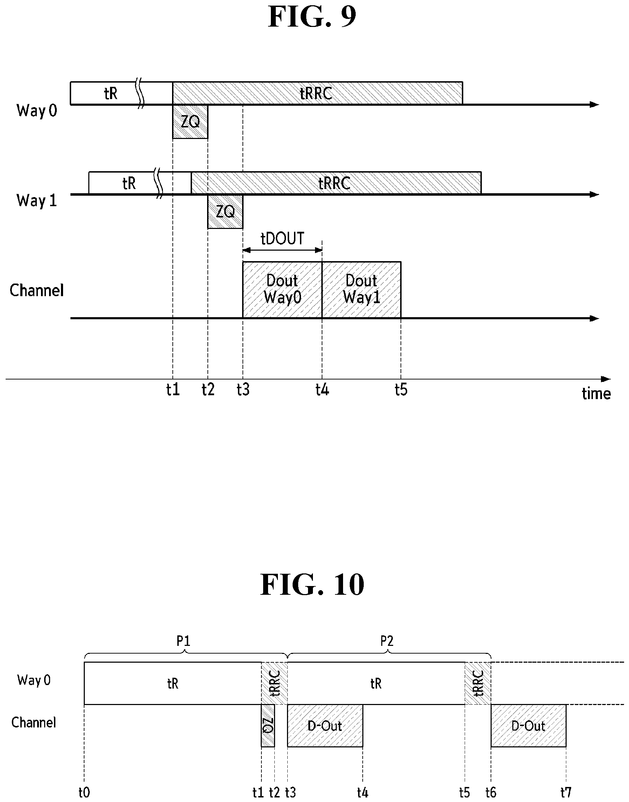

FIG. 9 is a timing diagram for explaining the channel status of the storage system of FIG. 5 in which the ZQ calibration is performed according to some embodiments.

Referring to FIG. 9, according to some embodiments, if the tRRC section is longer than the data output time tDOUT (tRRC>tDOUT), the storage controller may perform the ZQ calibration in the tRRC section. However, unlike FIG. 8, the ZQ calibration may be performed before all data of all non-volatile memory devices of the same channel are output.

For example, the storage controller 200 immediately performs the ZQ calibration on the first non-volatile memory device at time t1 when the first non-volatile memory device NVM11 switches to the tRRC section (ZQ). If the second non-volatile memory device NVM12 operates in the tRRC section at a time between the time t1 and the time t2, the ZQ calibration may be performed on the second non-volatile memory device NVM12 after the ZQ calibration of the first non-volatile memory device NVM11 is completed. In some embodiments, if the second non-volatile memory device NVM12 switches to the tRRC section at the time t2 when the ZQ calibration on the first non-volatile memory device is completed, the storage controller 200 may then perform the ZQ calibration on the second non-volatile memory device NVM12. For the sake of simplicity of description, in FIG. 9, it is assumed that a channel has two ways only. In some embodiments, the ZQ calibration of all non-volatile memory devices of the same channel may be completed before data read from the non-volatile memory devices start to be outputted through the channel.

After the ZQ calibration of all non-volatile memory devices NVM11 and NMV12 belonging to the same channel is completed at time t3, the non-volatile memory devices may sequentially output the read data to the channel (Dout WayO, Dout Way1).

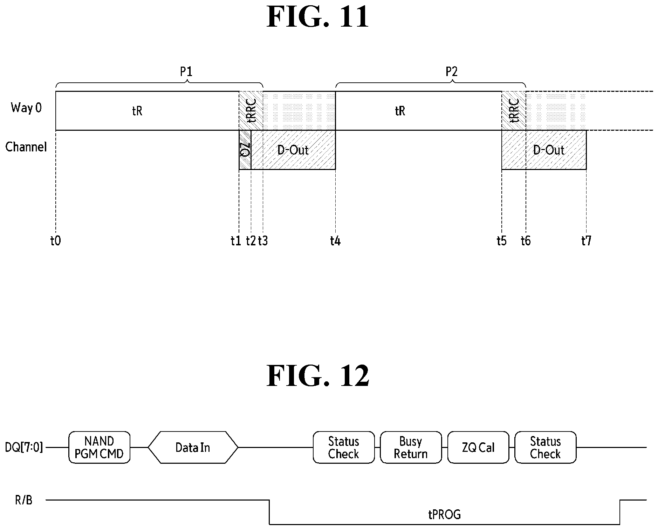

FIGS. 10 and 11 are timing diagrams for explaining the channel status of the storage system of FIG. 5 in which the ZQ calibration is performed according to some embodiments. For example, the data output time D-OUT may be longer than the time from read ready to new command tRRC. For example, the time from read ready to new command tRRC may be 5us to 15us which is shorter than the data output time.

Referring to FIG. 10, according to some embodiments, the storage controller 200 may continuously transmit the command to the non-volatile memory device 100. For example, the storage controller 200 may continuously transmit the command to the non-volatile memory device 200 regardless of whether data is output.

In FIG. 10, the storage controller 200 transmits a first read command, and when a first read operation for the first read command is completed during a read time P1 in the non-volatile memory device 100, that is, when the tRRC section of the read time P1 is completed, the storage controller 200 continuously transmits a second read command for a second read operation to be performed during a read time P2. The non-volatile memory device 100 continuously performs the first read operation during the read time P1 on the first read command and the second read operation during the read time P2 on the second read command. In some embodiments, the first read time P1 may include the memory-to-cell read time tR and the time from read ready to new command tRRC. In some embodiments, the first read time P1 may be equal to the second read time P2.

When the storage controller 200 transmits the read command to the non-volatile memory device 100, the non-volatile memory device 100 checks the status (Status Check) during the time t0 to time t1 as described in FIG. 4 or FIG. 6, and then reads data from the memory cell and stores it in the page buffer between time t0 and time t1 (i.e., during the memory cell-to-buffer read time tR), while returning whether it is in a busy status (Busy Return). Next, the non-volatile memory device 100 may perform the ZQ calibration during the time from read ready to new command tRRC (i.e., between time t1 and time t3). When the ZQ calibration is completed, the non-volatile memory device 100 waits for the next read command after checking whether the calibration is successful (Status Check).

After transmitting the read command corresponding to the first read operation performed during the read time P1, the storage controller 200 continuously transmits the next read command, when the non-volatile memory device 100 enters a ready status.

The data stored in the page buffer is output to the storage controller 200 after the time from read ready to new command tRRC elapses, that is, after time t3 when the second read operation on the non-volatile memory device 100 for the next read command is started, and the storage controller 200 receives the data of the first read operation performed during the read time P1, between time t3 and time t4.

The non-volatile memory device 100 outputs data for t6 to t7 after passing through the tR section (t3 to t5) and the tRRC section (t5 to t6) at which the data are read the memory cells by the next read command during the P2 section and discharged to the word line. In some embodiments, the non-volatile memory device 100 outputs data between time t6 and time t7 after the tR section (i.e., between time t3 and time t5) and the tRRC section (i.e., time t5 and time t6). During the second read operation performed in response to the next command, data read from the memory cells during the second read operation may be outputted during the P2 section.

Referring to FIG. 11, according to some embodiments, the storage controller 200 may transmit the command to the non-volatile memory device 100. However, unlike FIG. 10, the storage controller 200 of FIG. 11 may receive data associated with the first command after the first command transmission, and then transmit the second command.

For example, the storage controller 200 may send a first read command (Read) and send a second read command, after the data corresponding to the first read command of the first read operation (P1 section) performed on the non-volatile memory device is output. That is, the way WayO of the non-volatile memory device 200 may receive the next read command with a predetermined time interval (i.e., between time t3 and time t4) between the P1 section and the P2 section during which the data output D-Out of the first read operation is output to the channel.

For example, when the storage controller 200 transmits the first read command to the non-volatile memory device 100, the non-volatile memory device 100 performs a first read operation by the first read command in the P1 section. For example, during the time t0 to time 11, as described in FIG. 4 or FIG. 6, after the status check, the non-volatile memory device 100 returns whether the memory cell is in a busy status (Busy Return), reads the data from the memory cell and store the data in the page buffer (tR, time t0 to time 11). The non-volatile memory device 100 may perform the ZQ calibration during the time from read ready to new command tRRC (i.e., between time t1 and time t3) in which the word line is discharged. For example, the execution time of the ZQ calibration may be shorter than the time from read ready to new command tRRC.

When the ZQ calibration is completed, the non-volatile memory device 100 outputs the first data read by the first read command to the channel, after checking that the calibration is successful (Status Check). The storage controller 200 may transmit a second read command, after the first data is completely output at time t4.

Next, when the second read command is received after time t4, the non-volatile memory device 100 may perform the next data read operation in the P2 section on the basis of the reset channel status.

That is, the non-volatile memory device 100 of FIG. 11 may not receive commands continuously, and there may be a time gap between data output during the P1 section and the P2 section. For example, the time gap may correspond to a memory cell-to-buffer read time tR.

FIG. 12 is a timing diagram showing that the ZQ calibration is performed, while the non-volatile memory device of FIG. 5 performs the program operation, according to some embodiments.

Referring to FIG. 12, when the storage controller 200 transmits a program command (PGM CMD) and data to be programmed (DATA IN) through the DQ pin, the non-volatile memory device 100 transmits a logic-low ready/busy signal through the R/B pin during a program operation time tPROG. In the timing diagram, since the program operation is performed while the ready/busy signal is logic low, it is represented as the tPROG. For example, the time period during which the ready/busy signal has a level of a logic low corresponds to the tPROG.

While a logic-low ready/busy signal is being transmitted through the R/B pin during the tPROG, the storage controller 200 transmits the status checking command (Status Check), the non-volatile memory device 100 replies with a busy status (Busy Return), and the storage controller 200 performs the ZQ calibration with the non-volatile memory device 100 (ZQ Cal). After that, the storage controller 200 resumes the status check of the non-volatile memory device 100 for checking whether the ZQ calibration was successfully performed (Status Check).

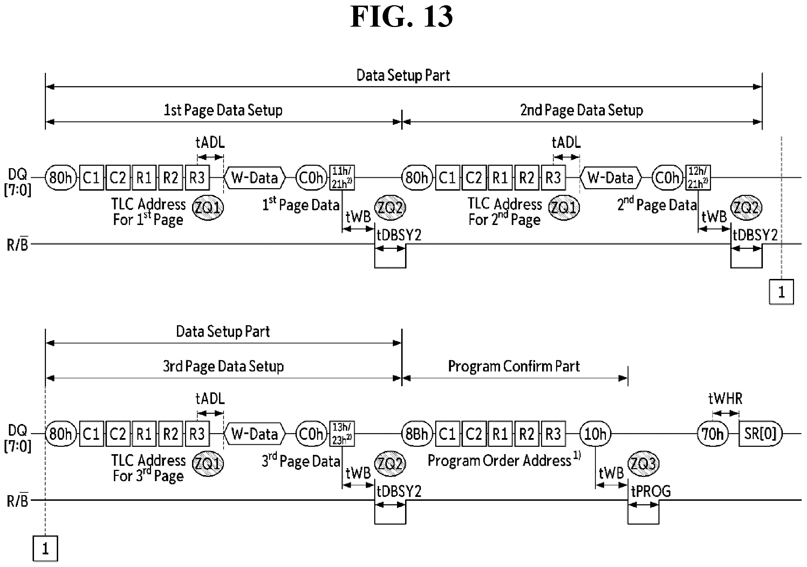

FIG. 13 is a timing diagram for explaining the channel status of the storage system of FIG. 5 in which the ZQ calibration is performed according to some embodiments.

Referring to FIG. 13, the storage controller 200 may perform the ZQ calibration for each page in a tADL (Address to Data Loading) section (i.e., an address-to-data loading time tADL) or a latch dump section (tDBSY2) (i.e., a latch dump time tDBSY2). The tADL section is a time which needs to wait during a program operation for a certain period of time without a data input. For example, the address-to-data loading time tADL indicates a waiting time before a data input starts in a program operation after the receipt of an address for the program operation (i.e., a delay between an address cycles and data cycles). The address-to-data loading time tADL may correspond to a reset time for resetting page buffers. The latch dump section (tDBSY2) is a section at which R/B pin is shortly in a busy status before subsequent data is input to the next page.

When programming the data into three pages in the non-volatile memory device according to some embodiments, the non-volatile memory device 100 transmits the data to be programmed for each page and performs data setup (Data Setup Part), and then completes the program operation after checking all the program data are successfully programmed (Program Confirm Part).

For example, the storage controller 200 transmits a program start command 80h and an address (C1, C2, R1, R2, and R3) for the memory cell array to the first page (1^{st} page) of the non-volatile memory device, then transmits the data (W-Data) to be programmed to the page buffer 104, and transmits the dump command COh and the dump designation command 11h. The dump designation command 11h may be, for example, a page buffer address that indicates the LSB page of the first page buffer PB1.

The storage controller 200 performs a first ZQ calibration on the first page (i.e., a data path between the data pin DQ and the page buffer) before transmitting the data to be programmed after transmitting the program command and address (ZQ1). After that, when the program activation signal busy time tWB elapses after the dump designation command 11h and the R/B pin enters a latch dump section (tDBSY2) status, the second ZQ calibration may be performed on the first page (i.e., a data path between the page buffer and the memory cell array).

The storage controller performs the first ZQ calibration on each of the second and third pages, similarly to the first page, before transmitting the data to be programmed after transmitting the program command and address on each of the second and third pages, and when the R/B pin enters the latch dump section (tDBSY2) status, the storage controller may perform the second ZQ calibration.

After completing the second ZQ calibration on the third page, when the latch dump section (tDBSY2) ends, the storage controller 200 outputs the addresses in a confirm sequence 88h and in the programmed order by the DQ pins (C1, C2, R1, R2, and R3), and outputs a triple-level cell (TLC) command set 10h. The TLC command set 10h may indicate the end of programming command. The R/B pin outputs a program busy signal during the tPROG, when a program activation signal busy time tWB elapses after outputting the TLC command set 10h. The program activation signal busy time tWB indicates a busy time during which no new commands are issued by the storage controller 200. The storage controller 200 may perform a third ZQ calibration ZQ3 during the tPROG section in which the program busy signal is being output from the R/B pin. After completing the third ZQ calibration, the storage controller 200 outputs a status register read command 70h, and the non-volatile memory device 100 transmits the status information SR and completes the program operation.

The storage controller 200 may perform the first ZQ calibration during the program operation according to an embodiment. In some embodiments, the storage controller 200 may perform the second ZQ calibration during the program operation. The storage controller 200 may perform the third ZQ calibration during the program operation according to an embodiment. In some embodiments, the storage controller 200 may perform at least two ZQ calibrations among the first ZQ calibration, the second ZQ calibration, and the third ZQ calibration together during the program operation.

After data to be programmed to a plurality of non-volatile memory devices are sequentially input to the channel according to an embodiment, the storage controller 200 may sequentially perform the ZQ calibration on each non-volatile memory device at a section in which the program operation is performed in each non-volatile memory device NVM11 and NVM12 through a way, for example, at a section in which the R/B pins of all non-volatile memory devices overlap in a busy status.

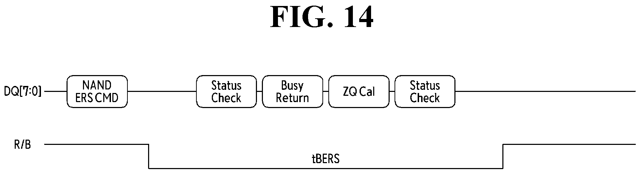

FIG. 14 is a timing diagram showing that the non-volatile memory device of FIG. 5 according to some embodiments performs the ZQ calibration during an erase operation.

Referring to FIG. 14, when the storage controller 200 transmits erase command (ERS CMD) through the DQ pin, the non-volatile memory device 100 transmits a logic-low ready/busy signal through the R/B pin during an erase operation time tBERS. In the timing diagram, because the erase operation is performed while the ready/busy signal is logic low, a timing period in which the ready/busy signal has a logic-low level corresponds to the erase operation time tBERS.

While the logic-low ready/busy signal is being transmitted through the R/B pin during the erase operation time tBERS, the storage controller 200 transmits the status check command (Status Check), the non-volatile memory device 100 replies with a busy status (Busy Return), and the storage controller 200 performs the ZQ calibration with the non-volatile memory device 100 (ZQ Cal). After that, the storage controller 200 resumes the status check of the non-volatile memory device 100 (Status Check).

FIG. 15 is a conceptual diagram showing a storage system connected in a separate command/address (SCA) manner according to some embodiments. Unlike FIG. 5, in FIG. 15, the storage controller 200 and the non-volatile memory device 100B are connected through an SCA interface. For convenience of explanation, repeated explanations of FIG. 5 will not be provided.

Referring to FIG. 15, in the SCA interface, the plurality of pins are connected between the storage controller 200 and the non-volatile memory device 100B in a separate command/address mode (hereinafter, SCA mode). Unlike the PIC mode described in FIG. 5, in the SCA mode, signal lines for transmitting commands and signal lines for transmitting addresses are separated from each other. Since the command signal line and the address signal line are separated in the SCA mode, the controller 200 may transmit the command or address signal to another signal line, even during access to the nonvolatile memory chip 100B through the DQ signal line. The plurality of pins may transmit, for example, DQ, R/B, DQS, RE, CA_CE, CA[0], CA[1], and CA_CLK signals, respectively. The DQ, R/B, DQS, and RE signals are described with reference to FIG. 5, and therefore detailed description thereof will not be provided.

A CA_CE is a command address chip enable signal, and is a signal which activates a specific non-volatile memory chip. A CA[0] signal is a signal line that transmits commands, a CA [1] is a signal line that transmits an address, and a CA_CLK signal is a clock signal line for the command and address signal lines. According to various embodiments, CA[1:0] may be referred to as command address signal line, and the DQ signal lines may be referred to as data signal line.

A CA_CLK signal is an external clock signal provided by the controller 200, and the non-volatile memory device 100B may generate a plurality of internal clocks from the CA_CLK signal by utilizing phase shifting or clock division techniques. The CA[0] signal may operate in conjunction with one of the plurality of internal clocks, and the CA[1] signal may operate in conjunction with the other of the plurality of internal clocks.

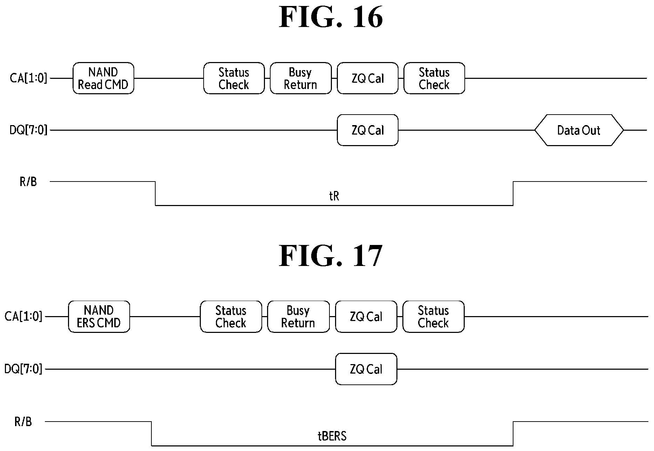

FIG. 16 is a timing diagram showing that the non-volatile memory device of FIG. 15 performs the ZQ calibration during a read operation, according to some embodiments.

Referring to FIG. 16, when the storage controller 200 transmits the read command (Read CMD) through the CA[1:0] pins, the non-volatile memory device 100 transmits logic-low ready/busy signal through the R/B pin during the read operation time tR.

While the logic-low ready/busy signal is being transmitted through the R/B pin, the storage controller 200 transmits a status check command (Status Check) through the CA[1:0] pin, the non-volatile memory device 100 replies with a busy status (Busy Return), and the storage controller 200 performs the ZQ calibration with the non-volatile memory device 100 (ZQ Cal). While the ZQ calibration of the CA[1:0] pin is being performed, the ZQ calibration is also performed on the DQ pin. In some embodiments, the ZQ calibration may be simultaneously performed on both the first signa line and the second sigma

FIG. 17 is a timing diagram showing that the non-volatile memory device of FIG. 15 performs the ZQ calibration during an erase operation, according to some embodiments.

Referring to FIG. 17, when the storage controller 200 transmits the erase command (ERS CMD) through the CA[1:0] pin, the non-volatile memory device 100 transmits a logic-low ready/busy signal through the R/B pin during the erase operation time tBERS.

While the logic-low ready/busy signal is being transmitted through the R/B pin during the erase operation time tBERS, the storage controller 200 transmits a status check command through the CA[1:0] pin (Status Check), the non-volatile memory device 100 replies with a busy status (Busy Return), and the storage controller 200 performs the ZQ calibration with the non-volatile memory device 100 (ZQ Cal). While the ZQ calibration of the CA[1:0] pin is being performed, the ZQ calibration is also performed on the DQ pin.

The storage controller 200 then checks the status of the non-volatile memory device 100 again through the CA[1:0] pin (Status Check), and when the non-volatile memory device 100 completes the erase operation, the R/B pin transmits a logic-high signal of the ready status.

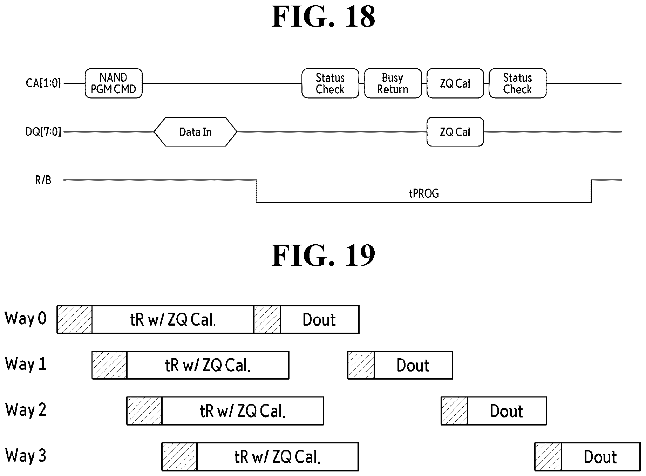

FIG. 18 is a timing diagram showing that the non-volatile memory device of FIG. 15 performs the ZQ calibration during a program operation, according to some embodiments.

Referring to FIG. 18, when the storage controller 200 transmits the program command (PGM CMD) through the CA[1:0] pin and transmits data through the DQ pin, the non-volatile memory device 100 transmits the logic-low ready/busy signal through the R/B pin during the program operation time tPROG.

While the logic-low ready/busy signal is being transmitted through the R/B pin during the program operation time tPROG, the storage controller 200 transmits the status check command through the CA[1:0] pins (Status Check), the non-volatile memory device 100 replies with the busy status (Busy Return), and the storage controller 200 performs the ZQ calibration with the non-volatile memory device 100 (ZQ Cal). The DQ pin also performs the ZQ calibration during the ZQ calibration of the CA[1:0] pin.

Thereafter, the storage controller 200 checks the status of the non-volatile memory device 100 again through the CA[1:0] pin (Status Check), and when the non-volatile memory device 100 completes the program operation, the R/B pin transmits the logic high signal of the ready status.

FIGS. 19 to 21 are timing diagrams for explaining an operating method of the storage system according to some embodiments. With reference to FIGS. 1 and 2 together, the storage system 1 includes the storage controller 200, and the plurality of non-volatile memory devices NVM11, NVM12, NVM13, and NVM14 connected through four ways Way0, Way1, Way2, and Way3 of the first channel CH1. For the simplicity of description, it is assumed that the first channel CH1 has four ways Way0 to Way 3 (i.e., four non-volatile memory devices NVM11 to NVM14) in FIG. 2.

Referring to FIG. 19, at the time of the read operation of the storage system 1, the plurality of non-volatile memory devices sequentially receive the read commands through each of the connected ways (Way), and output the read data to the storage controller 200 connected to the channel through the ways in the order in which the read commands are received. After receiving the read command for each non-volatile memory device, the storage controller 200 may perform the ZQ calibration before the output of the data.

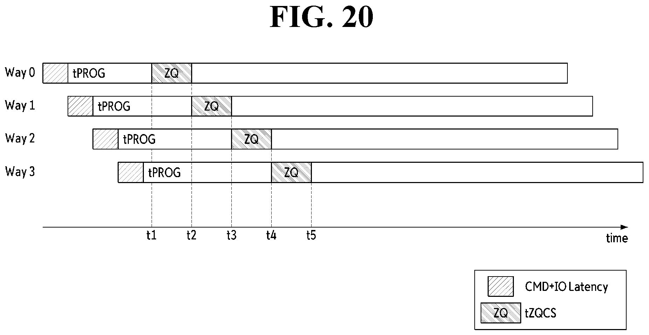

In the example shown in FIG. 20, the first non-volatile memory device NVM11 of the first way (Way0) receives the program command as described in FIG. 12, and if the R/B pin is in a busy status, the storage controller 200 performs the ZQ calibration on the first non-volatile memory device NVM11.

The second non-volatile memory device NVM12 of the second way (Way1) receives the program command, and if the R/B pin is in a busy status, the storage controller 200 performs the ZQ calibration on the second non-volatile memory device NVM12.

The third non-volatile memory device NVM13 of the third way (Way2) receives the program command, and if the R/B pin is in a busy status, the storage controller 200 performs the ZQ calibration on the third non-volatile memory device NVM13.

The fourth non-volatile memory device NVM14 of the fourth way (Way3) receives the program command, and if the R/B pin is a busy status, the storage controller 200 performs the ZQ calibration on the fourth non-volatile memory device NVM14.

That is, referring to FIG. 20, at the time of the program operation of the storage system 1, the plurality of non-volatile memory devices sequentially receive the program commands and data through each connected way, and may perform the ZQ calibration in order in which the program commands and data are received. Although the non-volatile memory devices connected to each way are in a busy status, the ZQ calibration according to the change in the operating environment may be re-performed in a situation in which the DMA (Direct Memory Access) and the tPROG sections overlap, thereby improving the SI performance.

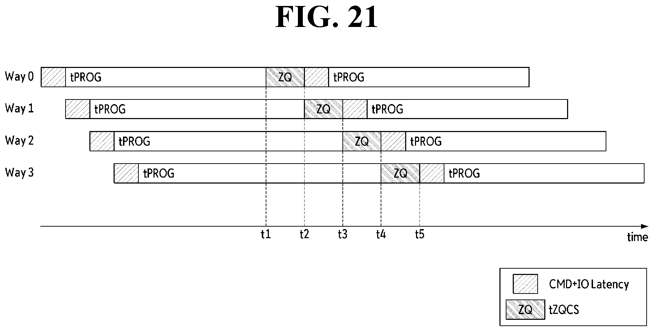

Referring to FIG. 21, at the time of the program operation of the storage system 1, the plurality of non-volatile memory devices sequentially receive the program commands and data through each of the connected ways. Unlike FIG. 20, in the ZQ calibration of FIG. 21, when the non-volatile memory device includes memory cells of quad bit level cells (QLC) or more, if a defense code operation needs to be performed in the first error bit determination situation, the ZQ calibration is first performed before the next program operation is performed during runtime, and the subsequent program command and data are received during the tPROG section. The ZQ calibration operation performed during runtime allows the actual cell itself to perform the error bit determination, rather than an error due to the interface, thereby improving the operating performance of the storage system.

Although the embodiments of the present invention have been described above with reference to the accompanying drawings, the present invention is not limited to the above embodiments, and may be fabricated in various different forms. Those skilled in the art will appreciate that the present invention may be embodied in other specific forms without changing the technical spirit or essential features of the present invention. Accordingly, the above-described embodiments should be understood in all respects as illustrative and not restrictive.

## Claims

1. An operating method of a storage system, the method comprising:
transmitting a first access command to a first non-volatile memory device;
checking a status of the first non-volatile memory device; and
performing a first ZQ calibration on the first non-volatile memory device through a DQ pin of the first non-volatile memory device during a time when the first non-volatile memory device is in a busy status.

2. The operating method of the storage system of claim 1, further comprising:
transmitting a second access command to a second non-volatile memory device;
checking a status of the second non-volatile memory device;
performing a second ZQ calibration on the second non-volatile memory device; and
outputting data sequentially from the first and second non-volatile memory devices when each of the first and second access commands is a read command,
wherein the first and second non-volatile memory devices are connected to a first channel,
wherein the first and second ZQ calibrations are performed sequentially on the first and second non-volatile memory devices which are in the busy status, and wherein the outputting of the data is performed after completing the first and second ZQ calibrations.

3. The operating method of the storage system of claim 1, further comprising:
transmitting a second access command to a second non-volatile memory device;
checking a status of the second non-volatile memory device;
performing a second ZQ calibration on the second non-volatile memory device; and
outputting data sequentially from the first and second non-volatile memory devices when each of the first and second access commands is a read command,
wherein the first and second non-volatile memory devices are connected to a first channel,
wherein the first ZQ calibration is performed during a time from read ready to new command (tRRC) of the first non-volatile memory device,
wherein the second ZQ calibration is performed during a tRRC of the second non-volatile memory device, and
wherein the outputting of the data sequentially includes:
outputting first data from the first non-volatile memory device after completing the first ZQ calibration, and
outputting second data from the second non-volatile memory device after completing the second ZQ calibration.

4. The operating method of the storage system of claim 1,
wherein the transmitting of the first access command includes transmitting an address of a page of the first non-volatile memory device and a program start command to the first non-volatile memory device when the first access command is a program command, and
wherein the performing of the first ZQ calibration is performed on the page of the first non-volatile memory device during an address-to-data loading time (tADL).

5. The operating method of the storage system of claim 1,
wherein the transmitting of the first access command includes transmitting an address of a page of the first non-volatile memory device and a program start command to the first non-volatile memory device when the first access command is a program command, and
wherein the first ZQ calibration is performed on the page of the first non-volatile memory device after a program activation signal busy time (tWB) elapses and during a latch dump time (tDBSY2).

6. The operating method of the storage system of claim 1,
wherein the transmitting of the first access command includes transmitting an address of a page of the first non-volatile memory device, a program confirmation command (88h), and a program start command (80h) to the first non-volatile memory device, and a program end command (10h) when the first access command is a program command, and
wherein the first ZQ calibration is performed on the page of the first non-volatile memory device during a program operation time (tPROG) after a program activation signal busy time (tWB) subsequent to the program confirmation command (88h).

7. A storage system comprising:
a storage controller; and
a plurality of non-volatile memory devices connected to the storage controller with a first signal line for transmitting a command and an address and a second signal line for transmitting data,
wherein the first signal line and the second signal line are separated from each other, and
wherein the storage controller is configured to:
transmit an access command as the command to a first non-volatile memory device of the plurality of non-volatile memory devices using the first signal line;
receive a logic level of a ready/busy signal using a R/B pin of the first non-volatile memory device during a time when an operation corresponding to the access command is performed on the first non-volatile memory device;
check a status of the first non-volatile memory device on the first signal line;
perform, in response to the logic level of the ready/busy signal representing a busy status, a ZQ calibration on the first non-volatile memory device; and
check, after the performing of the ZQ calibration, the status of the first non-volatile memory device.

8. The storage system of claim 7,
wherein the storage controller simultaneously performs the ZQ calibration on the first signal line and the second signal line of the first non-volatile memory device.

9. The storage system of claim 7,
wherein the access command is a read command, and
wherein the storage controller is configured to:
sequentially performs the ZQ calibration on the plurality of non-volatile memory devices during a time when each of the plurality of non-volatile memory devices are in the busy status, and sequentially receive data read from each of the non-volatile memory devices through the second signal line in an order in which the ZQ calibration is completed.

10. The storage system of claim 7,
wherein the storage controller is configured to:
sequentially output a plurality of program commands as the command to the plurality of non-volatile memory devices, and
perform the ZQ calibration, in an order of outputting the plurality of program commands, on the plurality of non-volatile memory devices.

11. The storage system of claim 10,
wherein the storage controller performs the ZQ calibration on the first non-volatile memory device, before a subsequent program operation is performed on the first non-volatile memory device.

12. The storage system of claim 10,
wherein the ZQ calibration is performed on a page of the first non-volatile memory device during an address-to-data loading time (tADL) after receiving a program start command as the command and the address through the first signal line.

13. The storage system of claim 10,
wherein the ZQ calibration is performed on a page of the first non-volatile memory device during a latch dump time (tDBSY2) after a program activation signal busy time (tWB) elapses.

14. The storage system of claim 10,
wherein the ZQ calibration is performed on a page of the first non-volatile memory device during a program operation time (tPROG), after a program activation signal busy time (tWB) subsequent to a program confirm command (88h) elapses, and
wherein a time period of the logic level of the ready/busy signal corresponds to the tPROG.

15. The storage system of claim 7,
wherein the access command is an erase command, and
wherein the storage controller sequentially performs the ZQ calibration on the plurality of non-volatile memory devices during a time when each of the plurality of non-volatile memory devices are in the busy status.
